# EUROPÄISCHE PATENTANMELDUNG

(11) **EP 2 373 143 A2**
(43) Veröffentlichungstag der Anmeldung: **05.10.2011**
(21) Anmeldenummer: 11160062.3
(22) Anmeldetag: 28.03.2011
(51) Int. Cl.: H05K 9/00

(54) **Elektronische Baueinheit in einem Raumflugkörper**

(30) Priorität: 01.04.2010 DE 102010016288
(71) Anmelder: Jena-Optronik GmbH, 07745 Jena (DE)
(72) Erfinder: Jörg, Riedel, 07747 Jena (DE)
(74) Vertreter: Ege, Guido

(57) **Zusammenfassung**

Die Erfindung betrifft eine elektronische Baueinheit (1) in einem Raumflugkörper mit zumindest einer mehrlagigen Leiterplatte (2) mit mehreren gleichartigen Funktionsmodulen (16) und einer thermisch leitenden Ableitlage (9). Zur gleichzeitigen Abschirmung der Funktionsmodule (16) gegeneinander und nach außen sowie einer Ableitung entstehender Wärme wird vorgeschlagen, eine für die zumindest eine Leiterplatte (2) vorgesehene Wärmeableit- und Schirmeinrichtung (7) vorzusehen, mittels der die Funktionsmodule (16) jeweils mittels eines eine Abschirmung und eine thermische Ableitung bildenden, thermisch und elektrisch leitenden und mit der zusätzlich elektrisch leitend ausgebildeten Ableitlage (9) verbundenen Funktionsmodulgehäuses (10) voneinander getrennt werden.

## Beschreibung

Die Erfindung betrifft eine elektronische Baueinheit in einem Raumflugkörper mit zumindest einer mehrlagigen Leiterplatte mit mehreren gleichartigen Funktionsmodulen und einer thermisch leitenden Ableitlage.

Elektronische Baueinheiten in Raumflugkörpern wie Satelliten, Raumstationen, Raumfähren und dergleichen haben hohe Anforderungen bezüglich Genauigkeit, Leistungsdichte, Gewicht und Störunempfindlichkeit zu erfüllen. Dabei sind derartige elektronische Baueinheiten hohen thermischen Belastungen bei wechselnden Temperaturen, Störstrahlungen und Störsignalen anderer elektronischer Komponenten ausgesetzt. Bei Verwendung mehrerer gleichartiger Funktionsmodule können sich diese untereinander stören (Crosstalk). Besondere Ansprüche beim Weltraumeinsatz von elektronischen Bauteilen ist infolge des vorherrschenden Vakuums die fehlende Möglichkeit der konvektiven Ableitung von Wärme beispielsweise durch Lüfter und dergleichen. Weiterhin sind aufgrund der beengten Raumverhältnisse insbesondere während des Transports des Raumflugkörpers in den Weltraum elektronische Baueinheiten mit elektronischen Schaltungen hoher Packungsdichte erforderlich, die bezogen auf deren Leiterplattenfläche ein hohes Wärmeaufkommen erzeugen.

In der EP 1 504 637 A1 wird eine Haltestruktur für ein elektronisches Gerät mit mehreren Leiterplatten offenbart, bei dem die Leiterplatten in einem gemeinsamen Gehäuse untergebracht sind und das mit einem wärmeableitenden Füllstoff in Form von Keramikpulver befüllt ist. Das Keramikpulver tritt in Kontakt mit den Bauelementen und leitet an diesen entstehende Wärme ab. Durch die pulverförmige Ausführung der Keramik und durch deren vorgegebene spezifische Wärmekapazität ist eine insbesondere schnelle Wärmeableitung begrenzt. Durch das große Volumen von mehreren ummantelten Leiterplatten in einem einzigen großen Gehäuse ist eine vergleichsweise große Menge Füllstoff mit entsprechend hohem Gewicht nötig. Durch die quasi nicht vorhandenen elektrischen Abschirmungseigenschaften gegen elektromagnetische Störungen sind die Bauelemente des elektronischen Geräts insbesondere gegenüber einem gegenseitigen Störeinfluss nicht ausreichend gesichert.

Weiterhin sind Leiterplatten bekannt, bei denen mehrere Lagen wie Leiterbahnen mit dazwischen liegenden elektrisch isolierenden Isolierschichten vorgesehen sind, wobei außen oder innerhalb der Leiterplatte eine dünne Wärmeableitschicht (heat sink) vorgesehen ist, die Wärme nach außen ableitet. Da die elektrisch isolierenden Isolierschichten zugleich schlechte Wärmeleiter sind und als thermische Widerstände wirken, müssen zur Abführung der an den Bauelementen entstehenden Wärme zusätzliche Wärmeleitpfade zu Wärmeableiteinrichtungen beispielsweise in Form von Durchkontaktierungen mit größerer Wärmeleitung durch die Isolierschichten geschaffen werden, die die Möglichkeit hoher Packungsdichten vereiteln und so gegebenenfalls durch Erhöhung der Anzahl der Lagen das Gewicht einer Leiterplatte erhöhen. Im Weiteren sind zusätzliche Entstörungsmaßnahmen vorzusehen. Weiterhin müssen zur Vermeidung von lateralen Verzügen derartiger Leiterplatten unter Wärmeeinfluss Materialien mit geringem Wärmeausdehnungskoeffizienten wie beispielsweise mehrschichtige Kupfer/lnvar/Kupferbeschichtungen (ClC) vorgesehen werden.

Aufgabe der Erfindung ist die vorteilhafte Weiterbildung eines Raumflugkörpers und einer elektronischen Baueinheit in einem Raumflugkörper insbesondere im Zusammenspiel der Ableitung von Wärme aus Komponenten dieser, einer Abschirmung gegenüber elektromagnetischen Einflüssen sowie einer Optimierung des durch diese beanspruchten Bauraums und damit einer Erhöhung der Leistungsdichte.

Die Aufgabe wird durch eine elektronische Baueinheit gemäß Anspruch 1 und durch einen Raumflugkörper gemäß Anspruch 10 gelöst. Die Unteransprüche 2 bis 9 und 11 beziehen sich auf vorteilhafte Ausführungsformen einer elektronischen Baueinheit beziehungsweise eines Raumflugkörpers.

Beispielsweise kann eine elektronische Baueinheit vorgesehen sein, die zumindest eine mehrlagige Leiterplatte mit mehreren gleichartigen Funktionsmodulen und eine thermisch leitenden Ableitlage enthält, wobei die Funktionsmodule mittels einer für die zumindest eine Leiterplatte vorgesehenen Wärmeableit- und Schirmeinrichtung mit einer eine Abschirmung und eine thermische Ableitung bildenden, thermisch und elektrisch leitenden Ableitlage und mittels jeweils eines mit dieser verbundenen Funktionsmodulgehäuses voneinander getrennt sind.

Gemäß dem erfinderischen Gedanken wird beispielsweise eine metallische Ableitlage trotz deren vergleichsweise hohen Gewichts eingesetzt, da diese zum Einen eine hohe spezifische Wärmeleitfähigkeit und zum Anderen eine elektrische Leitfähigkeit mit der Fähigkeit einer elektromagnetischen Abschirmung aufweist, so dass eine Doppelfunktion genutzt werden kann. In Verbindung mit den mit der Ableitlage verbundenen Gehäusen, die jeweils ein Funktionsmodul umschließen, wird dabei eine vollständige Kapselung der Funktionsmodule erzielt. Durch die Doppelfunktion wird ein Gewichtsvorteil erzielt, der die höhere Dichte der Ableitlage zumindest kompensiert. Im Weiteren beansprucht die Ableitlage mit den Funktionsmodulgehäusen weniger Bauraum als beispielsweise eine Füllung mit Füllstoff mit vergleichbarer Wärmekapazität. Dabei erfolgt die Ableitung entstehender Wärme aus den Bauteilen der Funktionsmodule oder anderer auf der zumindest einen Leiterplatte angeordneter, in ähnlicher Weise gekapselter Bauteile über direkte oder indirekte körperliche Ableitung zum Ableitblech und/oder über Wärmestrahlung gegenüber dem Funktionsmodulgehäuse, das durch dessen Ankoppelung an die Ableitlage die aufgenommene Wärme schnell an diese abgibt. Durch die Anbindung der elektronischen Bauelemente an die Ableitlage mittels des metallischen Kontakts der Masseableitung erfolgt zugleich eine direkte elektrische und thermische Ankopplung der Bauelemente an die Ableitlage, so dass der Wärmefluss der Bauelemente ohne einen thermischen Widerstand der elektrischen Isolierschichten der Leiterplatte direkt über die Ableitlage auf das Gehäuse erfolgen kann.

Die Ableitlage ist vorzugsweise aus einem gut wärmeleitfähigen Metall, beispielsweise Kupfer, Silber oder dergleichen sowie deren Legierungen gebildet. Dabei hat sich die Verwendung von Kupferlegierungen, die insbesondere bezüglich ihrer Wärmeleitfähigkeit, elektromagnetischen Störkomponentenisolation und/oder elektrischen Leitfähigkeit optimiert sind, als vorteilhaft erwiesen. Bezüglich deren Masse zur ausreichenden Ableitung von Wärme insbesondere bei Warmzyklen der im Weltraum extremen Temperaturwechsel werden bevorzugt Schichtdicken der Ableitlage in einer Stärke der Ableitlage zwischen 0,3 mm und 1,0 mm verwendet. Die Funktionsmodulgehäuse können aus Stahl oder demselben Material gefertigt sein und wahlweise eine entsprechende oder dünnere Materialstärke aufweisen. Zum Schutz gegen im Weltraum vorhandenen Oxidantien in Restkonzentrationen können die Ableitlage und die Funktionsmodulgehäuse einen Korrosionsschutz, beispielsweise eine Beschichtung wie Vergoldung, Vernickelung, eine Kunststoffschicht, eine Lackierung oder dergleichen aufweisen

Im Weiteren können zum Zweck einer direkten körperlichen Ankopplung der Bauelemente an die die Funktionsmodule umgebenden Funktionsmodulgehäuse die Funktionsmodulgehäuse mit thermisch leitendem Füllstoff befüllt werden. Dabei bleibt der modulare Aufbau der elektronischen Baueinheit mit einfach zu wechselnden Leiterplatten erhalten und das Füllvolumen bleibt auf die lediglich kleine Füllvolumina aufweisenden Funktionsmodulgehäuse beschränkt.

Die Ableitlage ist zumindest an einer Seite der zumindest einen Leiterplatte beispielsweise mit einem Rahmen, Gehäuse, einem Radiator oder dergleichen der elektronischen Baueinheit mittels einer guten Wärmekopplung, beispielsweise mittels einer direkten metallischen Kontaktierung, Wärmeleitfolie, eine temperaturstabilisierte Verschraubung und dergleichen verbunden. Dabei dient ein kälteres Bauteil, das in idealer Weise erwärmt werden soll, als Wärmesenke. Die Ableitung der Wärme der elektronischen Bauteile erfolgt dabei ausschließlich über die Ableitlage zum Gehäuse. Durch die rein metallische Ableitung der Wärme kann auf andere Formen der Wärmeabfuhr, beispielsweise Heatpipes verzichtet werden. Dabei hat sich durch die massive Ausgestaltung der Ableitlage als vorteilhaft erwiesen, dass diese mit dem Gehäuse der elektronischen Baueinheit beispielsweise mit einem mit diesem verbundenen Modulrahmen eine besonders gute, flächige wie plane Kontaktfläche ausbilden kann, die einen großen Wärmeaustausch ermöglicht. Beispielsweise können die Kontaktflächen zwischen Gehäuse beziehungsweise Modulrahmen aufeinander angepasst, beispielsweise spanend bearbeitet werden.

Durch die vorgeschlagene Ausführung der elektronischen Baueinheit können infolge der guten Wärmeleiteigenschaften der Ableitlage und der Gehäuse benachbarte Leiterplatten wie Platinen enger gestaffelt werden, so dass entsprechende Bauraumvorteile erzielt werden können. Weiterhin können die Funktionsmodule beidseitig im Wesentlichen symmetrisch zu der Ableitlage der zumindest einen Leiterplatte auf einem Raster angeordnet sein, so dass mit derselben Anzahl an Funktionsmodulen die Anzahl der Leiterplatten halbiert werden kann. Beispielsweise kann eine einzige Leiterplatte mit doppelt so vielen Funktionsmodulen ausgerüstet werden. Dabei bildet die Ableitlage für die einander gegenüberliegend angeordneten Funktionsmodule sowohl die thermische als auch die elektrische Kapselung, wodurch eine Bauraum- als auch Gewichtsersparnis erzielt werden kann. Unter wesentlich sind in diesem Sinne insbesondere eine Verdrehung der Funktionsmodule im Raster beispielsweise um 90° oder 180° gegenüber dem auf der anderen Seite der Ableitlage angeordneten Funktionsmodul, eine spiegelbildliche Anordnung der Bauelemente von Funktionsmodulen sowie eine spiegelbildliche Rasterung von Funktionsmodulen unter Beibehaltung eines nicht gespiegelten inneren Aufbaus und dergleichen zu verstehen.

Gemäß einem vorteilhaften Ausführungsbeispiel ist zwischen elektronischen Bauteilen und der Ableitlage eine isolierende Plattenschicht mit zumindest einer mit der Ableitlage verbundenen Masselage vorgesehen, so dass die einzelnen Massen der elektronischen Bauteile sowohl elektrisch als auch thermisch an die Ableitlage angebunden werden. Zur Verbesserung der elektrischen Schirmung und der thermischen Ableitung von Wärme hat sich dabei als vorteilhaft erwiesen, wenn für die elektronischen Bauteile jedes Funktionsmoduls voneinander vollständig isolierte Masselagen vorgesehen werden. Auf diese Weise werden die Massen der einzelnen Bauelemente eines Funktionsmoduls miteinander parallel in einer von den anderen Masselagen getrennten Masselage miteinander verbunden. Jede einzelne Masselage ist dabei mit der Ableitlage verbunden, die durch ihre große Dicke und damit hohe Leitfähigkeit Störungen sicher ableitet, ohne einzelne Störungen der Masselagen der einzelnen Funktionsmodule auf die anderen Masselage anderer Funktionsmodule zuzulassen. Dies hat den insbesondere den Vorteil einer erhöhten Störunempfindlichkeit der Funktionsmodule untereinander und einer kleineren Übersprechempfindlichkeit (verminderter crosstalk) und dergleichen. Weiterhin kann eine Betriebsspannungslage für jedes Funktionsmodul separat ausgebildet sein, wobei eine Zuführung der Betriebsspannung von außen über eine zentrale Zuleitung erfolgt, die in einzelne Betriebsspannungslagen der Funktionsmodule aufgeteilt wird, die auf der Platine voneinander getrennt wird. Schließlich kann die Ableitung der elektrischen Masse, also der negative Pol der Betriebsspannung in gleicher oder ähnlicher Weise durch einzelne, voneinander getrennte Lagen der Funktionsmodule in einer oder mehreren Schichten der Platine erfolgen kann. In besonders vorteilhafter Weise können die Betriebsspannungen der einzelnen Funktionsmodule über getrennte Filtereinheiten gegen elektromagnetische Störungen gefiltert sein. Hierzu können die Zuleitungen und die Ableitungen der Betriebsspannung jedes Funktionsmoduls jeweils über eine getrennte Filtereinheit verfügen. Um eine oder mehrere, bevorzugterweise alle Masselagen und Betriebsspannungslagen zusätzlich gegen Einstreuungen von außen oder gegen Einstreuungen anderer Schaltkreise oder elektronische Baugruppe, beispielsweise gegen Einstreuungen des die Funktionsmodule versorgenden Steuerteils abzuschirmen, kann ein weiterer Leiterzug, der die abzuschirmende(n) Masse- beziehungsweise Betriebsspannungslage(n) lateral um gibt. Ein derartiger Leiterzug kann gegenüber den abzuschirmenden Lagen in derselben oder einer anderen der mehrere Leitplattenlagen umfassenden Leiterplatte angeordnet sein. Es versteht sich, dass mehrere dieser Leiterzüge beispielsweise getrennt für Masselagen und Betriebsspannungslagen vorgesehen sein können. Weiterkann vorteilhaft sein, wenn jeweils mehrere Leiterzüge vorgesehen sind, die jeweils die Schaltkreise, Leiterbahnen und dergleichen eines Funktionsmoduls angeordnet sind, wobei diese einzeln oder gemeinsam mit der Ableitlage verbunden sein können. Gemäß einem vorteilhaften Ausführungsbeispiel können die Funktionsmodule von einem separaten Steuermodul zentral gesteuert werden. Dieses kann auf einer separaten oder auf einer Leiterplatte mit Funktionsmodulen angeordnet sein. In diesem Fall ist die entsprechende Leiterplatte in zwei Funktionsbereiche aufgeteilt, wobei ein Funktionsbereich die Funktionsmodule und der andere Funktionsbereich das Steuermodul enthält. Insbesondere aus Gründen der Verbesserung des Störeinflusses auf die Funktionsmodule kann vorgesehen sein, wenn jeder der beiden Funktionsbereiche eine Ableitlage aufweist. Dabei können die beiden Ableitlagen voneinander zumindest thermisch isoliert aber auch voneinander innerhalb der Mehrlagenleiterplatte elektrisch isoliert sein.

Die Funktionsmodule sind gemäß einem besonders vorteilhaften Ausführungsbeispiel zur Erfassung mehrerer analoger Signale verschiedener Sensoreinrichtungen wie beispielsweise Sensoren zur Erfassung von Spektralbereichen elektromagnetischer Strahlung, der Temperatur, ionisierender Strahlung und dergleichen vorgesehen. Diese Signale können verschiedene oder redundant erfasste Videosignale einer einzigen oder mehrerer Videoerfassungseinrichtungen wie Videokameras sein. Beispielsweise können derartige Signale als Videokanäle einer Videoprozessionsstrecke sein, die beispielsweise eine Vielzahl von Videokanälen aufweist. Diese können beispielsweise zur weltraumgestützten Erdbeobachtung mittels Erdbeobachtungsinstrumenten verwendet werden, wobei die vorgeschlagene Baueinheit einen Teil oder die vollständige Erfassungs- und Auswertungseinheit enthält. Die Erfassung der Signale der Videokanäle erfolgt dabei beispielsweise analog. Die Funktionsmodule enthalten dementsprechend Schaltkreise zur Aufnahme der von entsprechenden Bildprozessoren erfassten Videosignale und setzen das Analogsignal mittels einer Schaltung zur Analog-Digital-Wandlung in eine digitale Information um, die beispielsweise in dem Steuermodul weiterverarbeitet wird. Das Steuermodul kann auf die Funktionsmodule beispielsweise zur Steuerung der Taktrate von Erfassungs- und Verarbeitungszyklen zur Steuerung der Verstärkung und dergleichen bidirektional einwirken und entsprechend aufbereitet, digitalisierte Daten auslesen und weiterverarbeiten, beispielsweise in einem integrierten Speicher speichern oder in einem externen Speicher ablegen, per Leitungsanschluss auf eine Sendeeinheit übertragen oder mittels eines integrierten Senders an eine interne oder externe Empfangsstation senden. Es versteht sich, dass entsprechende Funktionen in der elektronischen Baueinheit von anderen Leiterplatten übernommen werden können.

In vorteilhafter Weise wird die Aufgabe durch einen Raumflugkörper, vorzugsweise einem Gerät zur weltraumgestützten Erdbeobachtung mit einer in den Anmeldungsunterlagen beschriebenen elektronischen Baueinheit gelöst. Nach dem erfinderischen Gedanken kann hierbei vorgesehen werden, dass aus der elektronischen Baueinheit abgeleitete Wärme einer Wärmebedarfseinrichtung zugeführt wird. Beispielsweise kann ein Wärmespeicher vorgesehen sein, der Wärme aufnimmt und dem Raumflugkörper bei Kaltzyklen im Weltraum wieder zur Verfügung stellt.

Die Erfindung wird anhand des in den Figuren 1 bis 4 dargestellten Ausführungsbeispiels näher erläutert. Dabei zeigen:
- Figur 1: einen Schnitt durch eine elektronische Baueinheit mit einer mit einer Wärmeableiteinrichtung versehenen Leiterplatte,
- Figur 2: einen Teilschnitt durch die Leiterplatte der Figur 1,
- Figur 3 und: eine Ansicht der teilbestückten Leiterplatte der Figur 1
- Figur 4: die vollständig bestückte Leiterplatte der Figur 1 mit teilweise einsehbaren Funktionsmodulen.

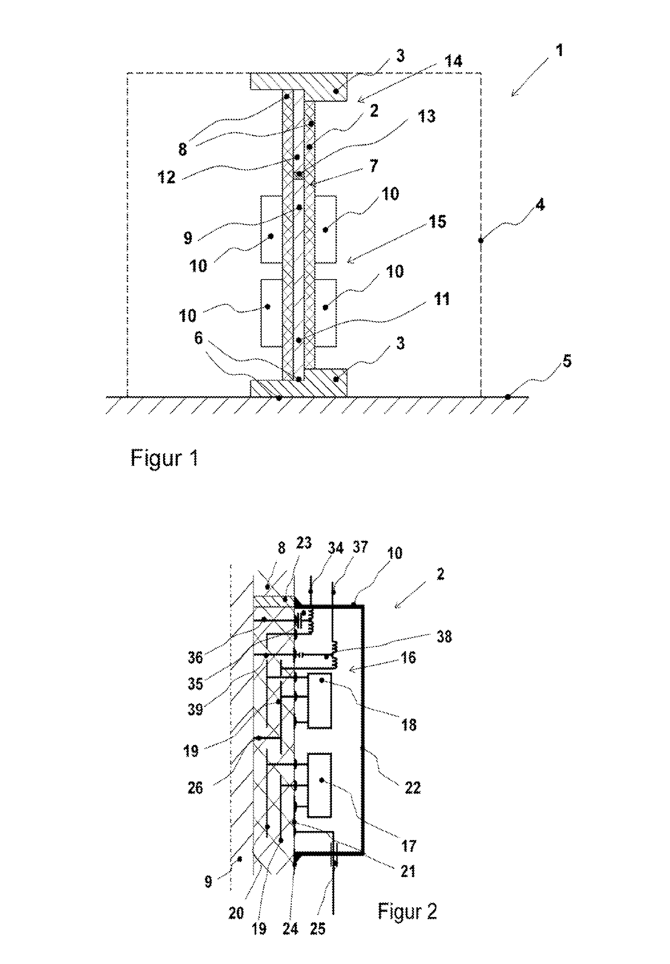

Figur 1 zeigt einen Schnitt durch die elektronische Baueinheit 1 mit der Leiterplatte 2, die mittels des Modulrahmens 3 in dem lediglich gestrichelt angedeuteten Gehäuse 4 der elektronischen Baueinheit 1 untergebracht ist. Das Gehäuse 4 kann eine mechanische, elektromagnetische und/oder thermische Schutzfunktion über gegebenenfalls allen in dem Gehäuse 4 vorgesehenen und in entsprechenden Modulrahmen untergebrachten Leiterplatten, von denen lediglich die Leiterplatte 2 dargestellt ist, und weiteren - nicht dargestellten - Modulen ausüben. Die elektronische Baueinheit 1 ist in einem Raumflugkörper, beispielsweise einem Satelliten, beispielsweise in Form eines weltraumgestützten Erdbeobachtungsinstruments wie Multispektralimager untergebracht.

Die Leiterplatte 2 ist mittels des Modulrahmens 3 einerseits an dem Gehäuse 4 und andererseits an dem Anbauinterface 5 zumindest gehalten wie eingesteckt. Der Modulrahmen 3 ist thermisch gekoppelt mit dem Anbauinterface 5, dieses kann temperiert beziehungsweise thermostatisiert sein, so dass ein Ausgleich der starken Kalt-/Warm-Zyklen auch auf die elektronische Baueinheit 1 wirksam ist, wobei die thermische Anbindung der elektronischen Baueinheit 1 an das Anbauinterface 5 zusätzlich eine Wärmeabfuhr der durch die elektronischen Bauteile der Leiterplatte 2 erzeugten Wärme gewährleistet. Hierzu ist ein Wärmefluss durch einen Temperaturgradienten zwischen Leiterplatte 2 und Anbauinterface 5 sowie beispielsweise durch Metallkontakte 6 und/oder Leitpaste erhöhte Wärmeflüsse zwischen der Leiterplatte 2, dem Modulrahmen 3 und dem Anbauinterface 5 vorgesehen. Das Anbauinterface 5 kann einen Wärmespeicher enthalten, der von der Leiterplatte 2 und gegebenenfalls weiteren - nicht dargestellten - Leiterplatten Wärme für die Kaltzyklen der Weltraumumgebung aufnimmt. Der Modulrahmen 3 kann aus wärmeleitfähigem Material, beispielsweise aus einer Aluminiumlegierung hergestellt sein.

Zur besseren Ableitung der Wärme aus der Leiterplatte 2 und zur elektrischen Schirmung ist diese mit der Wärmeableit- und Schirmeinrichtung 7 versehen, die aus der mittig zwischen den beiden mehrlagig ausgebildeten Platinen 8 zur Aufnahme und Verschaltung der auf der Leiterplatte angeordneten - nicht explizit dargestellten - elektronischen Bauelemente angeordneten Ableitlage 9 und den Funktionsmodulgehäusen 10 gebildet sind. Die Ableitlage 9 kann durch ihre ausgeprägte Stärke umlaufend und plan an den Modulrahmen angepasst, beispielsweise entsprechend zugefräst werden, so dass ein inniger Kontakt mit besonders guter Wärmeübertragung zum Modulrahmen 3 und anschließend zum Gehäuse 4 und Anbauinterface 5 geschaffen wird. Die Ableitlage 9 sowie alle weiteren korrosionsgefährdeten Bauteile der elektronischen Baueinheit 1 können zum Schutz gegen korrosive Restanteile im Weltraum mit einer Schutzschicht versehen sein, beispielsweise lackiert oder mit einem metallischen Überzug versehen, beispielsweise vernickelt sein. Die Funktionsmodulgehäuse 10 umschließen in Verbindung mit der Ableitlage 9 einen Raum, in dem einzelne, in den nachfolgenden Figuren detailliert dargestellte Funktionsmodule untergebracht sind und die durch die Ableitlage 9 und die Funktionsmodulgehäuse 10 jeweils gegeneinander und nach außen sowohl elektromagnetisch als auch thermisch rundherum in alle Richtungen, das heißt, 3-dimensional isoliert sind.

Die Ableitlage 9 ist aus vergleichsweise dickem, vorzugsweise zwischen 0,3 mm und 1,0 mm starkem Metall, bevorzugt einem wärmeleitfähigen und elektrisch leitfähigen Material, bevorzugt Kupfer oder einer Legierung mit diesem hergestellt. Durch die hohe Materialdicke werden neben einer guten Wärmeleitung Ladungsverschiebungen der als elektrische Masse geschalteten Ableitlage 9 vermieden oder zumindest größtenteils ausgeschlossen. In dem gezeigten Ausführungsbeispiel ist die Ableitlage 9 zweiteilig in einen Ableitteil 11 unter den Funktionsmodulgehäusen 10 und damit den Funktionsmodulen zugeordnet und einen Ableitteil 12 ausgebildet, der einem vorzugsweise digitalen Steuerteil der Funktionsmodule zugeordnet ist. Durch die Isolierung 13 wird die Leiterplatte 2 funktionsseitig in die beiden Funktionsbereiche 14, 15 mit jeweils separater elektrischer Masse unterteilt.

Figur 2 zeigt einen detaillierten Teilschnitt durch die Leiterplatte 2, wobei lediglich eine Hälfte dieser mit einem Schnitt durch die Ableitlage 9 und lediglich ein in dem Funktionsmodulgehäuse 10 untergebrachtes Funktionsmodul 16, vorzugsweise ein Schaltkreis zur Abbildung eines Videokanals, dargestellt ist. Die einzelnen elektronischen und sonstigen Bauelemente 17, 18 des Funktionsmoduls 16 sind mit der mehrlagigen Platine 8 entsprechend dem zugrundeliegenden Schaltplan verbunden. Hierbei sind in der Platine 8 mehrere Lagen zur Einbindung der Bauelemente 17, 18 in die Schaltung des Funktionsmoduls 16 vorgesehen, beispielsweise die Masselage 19, die Betriebsspannungslage 20 zur Bereitstellung der Betriebsspannung und die Leiterbahnlage 21 zur Verschaltung der Bauelemente 17, 18. Die einzelnen Kontakte der elektronischen Bauteile 17, 18 sind mit zugehörigen Lötpunkten mit den Lagen in üblicher Weise verbunden. Zwischen diesen leitenden Lagen sind jeweils nichtleitende Lagen angeordnet und bilden die Platine 8. Das Funktionsmodulgehäuse 10 bildet dabei die Schirmung 22 für jedes der Funktionsmodule 16, wobei die Funktionsmodulgehäuse 10 mittels der Durchkontaktierungen 23 durch die Platine 8 hindurch direkt mit der Ableitlage 9 verbunden sind. Zur Optimierung der Schirmungswirkung wird im Weiteren der geschlossene, hier auf der Oberfläche der Platine 8 aufgebrachte, einer verbesserten Abschirmung dienende Leiterzug 24 unabhängig und isoliert von der Leiterbahnlage 21 geführt. Eine Anordnung des schirmenden Leiterzugs 24 kann auch in einer Zwischenlage vorgesehen sein. Zumindest ein alle Funktionsmodule umgebender und/oder jeweils ein um die Leiterbahnen der Funktionsmodule 16 gezogener Leiterzug 24 umgibt in bevorzugter Weise die Masse-, Betriebsspannungs- und/oder Leiterbahnlagen 19, 20, 21 und schirmt diese nach außen ab. Dabei können alle Leiterbahnen umfassend, einzelne Leiterbahntypen eines oder mehrerer Funktionsmodule 16 gemeinsam und/oder die Leiterbahnen eines Funktionsmodul der einzelnen Funktionsmodule getrennt voneinander von einem oder mehreren Leiterbahnzügen umgeben sein.

Die Spannungsversorgung der Betriebsspannungslage 20 erfolgt mittels der Betriebsspannungsleitung 34, die durch das Funktionsmodulgehäuse 10 geführt ist und mittels der Filtereinheit 35 geschirmt ist. Die als Schirm wirksame Filtereinheit 35 ist direkt mittels der Schirmleitung 36 mit der Ableitlage 9 verbunden. Das analoge Messsignal beispielsweise eines Videokanals wird mittels der geschirmten Signalleitung 25 dem Funktionsmodul 16 zugeführt. Es versteht sich, dass auch mehrere Messsignale in einem Funktionsmodul 16 verarbeitet werden können. Dementsprechend werden mehrere geschirmte Signalleitungen 25 mit einer oder mehreren gegebenenfalls zusätzlich geschirmten Seelen bevorzugt durch das Funktionsmodulgehäuse 10 dem Funktionsmodul 16 zugeführt. Die in dem Funktionsmodul 16 vorhandenen Schaltkreise verfügen über zumindest eine Stromrückführung 37, die mittels der Filtereinheit 38 abgeschirmt und mittels der durch die Platine 8 geführten Masserückführung 39 an die Ableitlage 9 gekoppelt ist.

Die lageübergreifende Verbindung der Masselagen 19 der Funktionsmodule 16 mit der Ableitlage 9 erfolgt mittels der Durchkontaktierungen 26. Die Masselagen 19 der einzelnen Funktionsmodule 16 sind über die Durchkontaktierung 26 bevorzugt jeweils separat mit der Ableitlage 9 in Reihe geschaltet. Auf diese Weise werden Massenflüsse und das Übersprechen von Störungen zwischen den einzelnen Funktionsmodulen wie Videokanälen vermieden.

Zumindest die Masselagen 19, vorteilhafterweise auch die Betriebsspannungslagen 20 sind für jedes Funktionsmodul 16 getrennt ausgebildet. Dabei ist jede Masselage 19 für sich mit der Ableitlage 9 kontaktiert, so dass eine Ableitung von Störungen für jede Masselage 19 getrennt in die gut leitfähige Ableitlage 9 erfolgt, so dass ein crosstalk zwischen den Masselagen ausgeschlossen ist beziehungsweise auf ein ausreichendes Maß unterbunden wird. In gleichem Sinne wird ein crosstalk der Funktionsmodule 16 über die Betriebsspannungslagen 20 zumindest eingeschränkt, wenn diese über jeweils voneinander getrennte Betriebsspannungslagen 20 versorgt werden. Dabei kann beispielsweise jedes Funktionsmodul 16 mittels einer galvanisch getrennt von den anderen Betriebsspannung erzeugten Betriebsspannung versorgt werden.

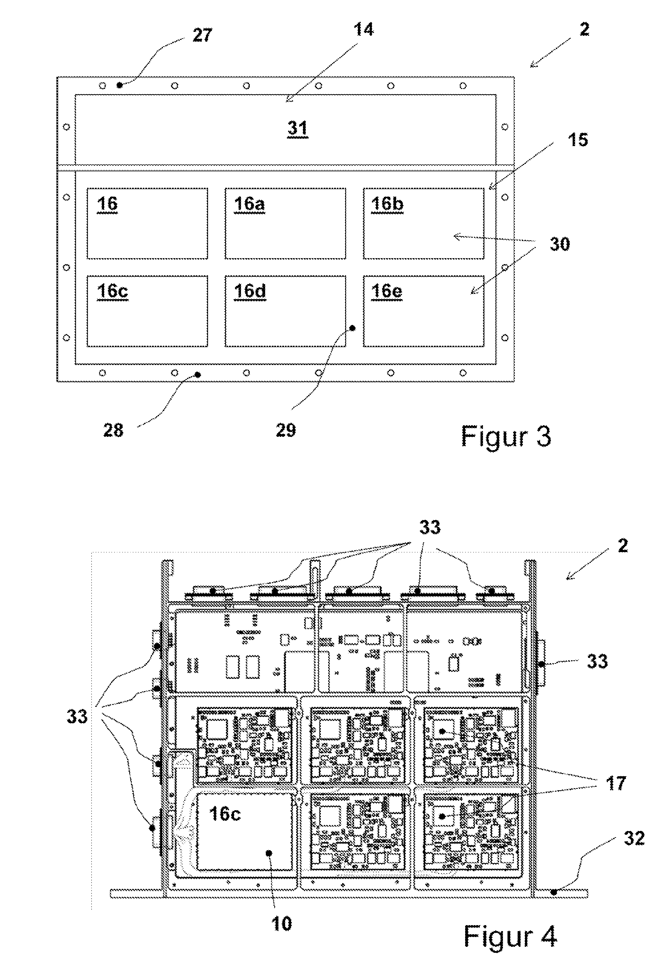

Die Figur 3 zeigt eine Übersicht über die Leiterplatte der Figuren 1 und 2 in Teilbestückung. Die Leiterplatte 2 umfasst die beiden Funktionsbereiche 14, 15 mit den Montagebereichen 27, 28, die eine getrennte Aufnahme der in Figur 1 gezeigten Ableitteile 11, 12 an dem Anbauinterface 5 (Figur 1) mittels einer thermisch leitenden Verbindung und eine Trennung der Ableitlage 9 (Figur 1 ) für die beiden Funktionsbereiche 15, 14 erlaubt. Der Funktionsbereich 15 enthält die auf dem Raster 29 angeordneten Funktionsmodule 16, 16a, 16b, 16c, 16d, 16e, die in dem gezeigten Ausführungsbeispiel als gleichartige Videokanäle 30 ausgebildet sind, die analoge Videosignale empfangen und mittels eines A/D-Wandlers digitalisieren. Auf der gegenüberliegenden Seite sind weitere Funktionsmodule im spiegelbildlichen Raster zu den Funktionsmodulen 16, 16a, 16b, 16c, 16d, 16e angeordnet, so dass mittels der Leiterplatte 2 im gezeigten Ausführungsbeispiel zwölf Funktionsmodule wie Videokanäle angeordnet werden können. Durch deren spiegelbildliche Anordnung kann neben der Einsparung von Bauraum eine gleichmäßige thermische Belastung auf beiden Seiten der Leiterplatte 2 eingestellt werden, so dass thermisch abhängige Verzüge der Leiterplatte 2 vermieden werden können.

Im Funktionsbereich 14 ist der im Wesentlichen digital arbeitende Steuerteil 31 untergebracht, der die Funktionsmodule 16, 16a, 16b, 16c, 16d, 16e und gegebenenfalls auf der Rückseite angeordnete Funktionsmodule steuert und überwacht, beispielsweise deren Taktrate zur A/D-Wandlung, deren Verstärkung, deren Langzeitverhalten, Funktion und dergleichen.

Figur 4 zeigt eine Ansicht der fertig bestückten, in dem Rahmen 32 aufgenommenen und mit entsprechenden Steckverbindern 33 versehenen Leiterplatte 2. An dem Beispiel des Funktionsmoduls 16c ist die thermische Kapselung und Schirmung durch das Funktionsmodulgehäuse 10 gezeigt, die übrigen Funktionsmodule geben einen Einblick in die im Wesentlichen gleich ausgebildete Schaltung mit den beispielweise näher bezeichneten Bauelementen 17. Die Steckverbinder stellen den elektrischen Kontakt zwischen zusätzlichen Leiterplatten der elektronischen Baueinheit 1 (Figur 1 ) und/oder anderen Elektronikeinheiten des Raumflugkörpers her.

### Bezugszeichenliste

- 1: elektronische Baueinheit
- 2: Leiterplatte
- 3: Modulrahmen
- 4: Gehäuse
- 5: Anbauinterface
- 6: Metallkontakt
- 7: Wärmeableit- und Schirmeinrichtung
- 8: Platine
- 9: Ableitlage
- 10: Funktionsmodulgehäuse
- 11 1: Ableitteil
- 12: Ableitteil
- 13: Isolierung
- 14: Funktionsbereich
- 15: Funktionsbereich
- 16: Funktionsmodul
- 16a: Funktionsmodul
- 16b: Funktionsmodul
- 16c: Funktionsmodul
- 16d: Funktionsmodul
- 16e: Funktionsmodul
- 17: Bauelement
- 18: Bauelement
- 19: Masselage
- 20: Betriebsspannungslage
- 21: Leiterbahnlage
- 22: Schirmung
- 23: Durchkontaktierung
- 24: Leiterzug
- 25: Signalleitung
- 26: Durchkontaktierung
- 27: Montagebereich
- 28: Montagebereich
- 29: Raster
- 30: Videokanal
- 31: Steuerteil
- 32: Rahmen
- 33: Steckverbinder
- 34: Betriebsspannungsleitung
- 35: Filtereinheit
- 36: Schirmleitung
- 37: Stromrückführung
- 38: Filtereinheit
- 39: Masserückführung

## Patentansprüche

1. Elektronische Baueinheit (1) mit zumindest einer mehrlagigen Leiterplatte (2), die mehrere mit elektronischen Bauelementen (17, 18) versehene elektronische Funktionsmodule (16, 16a, 16b, 16c, 16d, 16e) aufweist, **dadurch gekennzeichnet, dass** die zumindest eine Leiterplatte (2) eine Ableitlage (9) aufweist, die als thermische Ableit- und als elektrische Schirmlage fungiert, und den Funktionsmodulen (16, 16a, 16b, 16c, 16d, 16e) jeweils ein Funktionsmodulgehäuse (10) zur elektrischen Schirmung zugeordnet ist, das mit der Ableitlage (9) derart verbunden ist, dass die Funktionsmodulgehäuse (10) eine Wärmeableit- und Schirmeinrichtung (7) für die Funktionsmodule (16, 16a, 16b, 16c, 16d, 16e) bilden, wobei die Funktionsmodule (16, 16a, 16b, 16c, 16d, 16e) jeweils separate Betriebsspannungslagen (20) und separate, mit der Ableitlage (9) verbundene Masselagen (19) aufweisen und von zumindest einem geschlossenen Leiterzug (24) umgeben sind.

2. Elektronische Baueinheit (1) nach Anspruch 1, **dadurch gekennzeichnet, dass** Betriebsspannungsleitungen (34) und Stromrückführungen (37) der Funktionsmodule (16, 16a, 16b, 16c, 16d, 16e) voneinander mittels Filtereinheiten (35, 38) abgeschirmt sind.

3. Elektronische Baueinheit (1) nach Anspruch 1 oder 2, **dadurch gekennzeichnet, dass** die Funktionsmodule (16, 16a, 16b, 16c, 16d, 16e) beidseitig symmetrisch zu der Ableitlage (9) der zumindest einen Leiterplatte (2) auf einem Raster (29) angeordnet sind.

4. Elektronische Baueinheit (1) nach einem der Ansprüche 1 bis 3, **dadurch gekennzeichnet, dass** die zumindest eine Leiterplatte (2) einen ersten Funktionsbereich (15) mit den Funktionsmodulen (16, 16a, 16b, 16c, 16d, 16e) und einen zweiten Funktionsbereich (14) mit einem Steuerteil (31) zur Steuerung der Funktionsmodule (16, 16a, 16b, 16c, 16d, 16e) aufweist.

5. Elektronische Baueinheit (1) nach Anspruch 4, **dadurch gekennzeichnet, dass** die Betriebsspannungslagen (20) von dem zweiten Funktionsbereich (14) getrennt mittels einer gefilterten Betriebsspannung versorgt sind.

6. Elektronische Baueinheit (1) nach Anspruch 4 oder 5, **dadurch gekennzeichnet, dass** jeder der beiden Funktionsbereiche (14, 15) einen Ableitteil (11, 12) der Ableitlage (9) aufweist und die beiden Ableitteile (11, 12) voneinander mittels einer Isolierung (13) innerhalb der zumindest einen Leiterplatte (2) thermisch und/oder elektrisch isoliert und ausschließlich über ein Gehäuse (4) der elektronischen Baueinheit in einem elektrischen Massepfad miteinander verbunden sind.

7. Elektronische Baueinheit (1) nach einem der Ansprüche 1 bis 6, **dadurch gekennzeichnet, dass** die Funktionsmodule (16, 16a, 16b, 16c, 16d, 16e) jeweils eine Schaltung zur Erfassung und Analog-Digital-Wandlung eines analogen Signals einer Sensoreinrichtung enthalten.

8. Elektronische Baueinheit (1) nach einem der Ansprüche 1 bis 7, **dadurch gekennzeichnet, dass** die Ableitlage (9) aus einer auf Wärmeleitung abgestimmte Kupferlegierung mit einer Stärke zwischen 0,3 mm und 1 mm gebildet ist.

9. Elektronische Baueinheit (1) nach einem der Ansprüche 1 bis 10, **dadurch gekennzeichnet, dass** die Ableitlage (9) mit einer Wärmesenke verbunden ist.

10. Raumflugkörper mit einer elektronischen Baueinheit (1) nach einem der Ansprüche 1 bis 9, **dadurch gekennzeichnet, dass** in der elektronischen Baueinheit (1) entstehende Wärme über die Ableitlage (9) an das Gehäuse (4) abgeführt wird.

11. Raumflugkörper nach Anspruch 10, **dadurch gekennzeichnet, dass** aus der elektronischen Baueinheit (1) abgeleitete Wärme einer Wärmebedarfseinrichtung zugeführt wird.
